# EUROPÄISCHE PATENTSCHRIFT

(11) **EP 1 197 132 B1**
(45) Veröffentlichungstag und Bekanntmachung des Hinweises auf die Patenterteilung: **16.06.2004**
(21) Anmeldenummer: 00958138.0
(22) Anmeldetag: 17.07.2000
(51) Int. Cl.: H05K 13/00

(54) **STÜTZSTIFT UND GRUNDPLATTE ZUM UNTERSTÜTZEN VON SUBSTRATEN IN BESTÜCKAUTOMATEN**
SUPPORT ROD AND BASE PLATE FOR SUPPORTING SUBSTRATES IN COMPONENT MOUNTING MACHINES
TIGE DE SOUTIEN ET PLAQUE DE BASE POUR SOUTENIR DES SUBSTRATS DANS DES MACHINES AUTOMATISEES D'IMPLANTATION DE COMPOSANTS

(30) Priorität: 16.07.1999 DE 19933538
(43) Veröffentlichungstag der Anmeldung: 17.04.2002
(73) Patentinhaber: SIEMENS AKTIENGESELLSCHAFT, 80333 München (DE)
(72) Erfinder: DÜBEL, Rainer, D-85598 Baldham (DE)
(86) Internationale Anmeldenummer: PCT/DE2000/002317
(87) Internationale Veröffentlichungsnummer: WO 2001/006823

(56) Entgegenhaltungen:
- PATENT ABSTRACTS OF JAPAN vol. 1997, no. 11, 28. November 1997 (1997-11-28) & JP 09 181496 A (NEC NIIGATA LTD), 11. Juli 1997 (1997-07-11) in der Anmeldung erwähnt
- PATENT ABSTRACTS OF JAPAN vol. 1995, no. 04, 31. Mai 1995 (1995-05-31) & JP 07 022794 A (TAIHO SEIKI KK), 24. Januar 1995 (1995-01-24)
- PATENT ABSTRACTS OF JAPAN vol. 017, no. 110 (E-1329), 8. März 1993 (1993-03-08) & JP 04 293300 A (FUJI MACH MFG CO LTD), 16. Oktober 1992 (1992-10-16) in der Anmeldung erwähnt
- PATENT ABSTRACTS OF JAPAN vol. 1998, no. 11, 30. September 1998 (1998-09-30) & JP 10 163697 A (TOSHIBA CORP;TOSHIBA COMPUT ENG CORP), 19. Juni 1998 (1998-06-19)
- PATENT ABSTRACTS OF JAPAN vol. 014, no. 467 (E-0989), 11. Oktober 1990 (1990-10-11) & JP 02 190000 A (TDK CORP), 25. Juli 1990 (1990-07-25) in der Anmeldung erwähnt
- PATENT ABSTRACTS OF JAPAN vol. 018, no. 570 (E-1623), 31. Oktober 1994 (1994-10-31) & JP 06 209195 A (MATSUSHITA ELECTRIC IND CO LTD), 26. Juli 1994 (1994-07-26) in der Anmeldung erwähnt

## Beschreibung

Die Erfindung bezieht sich auf eine Grundplatte sowie einen Stützstift zum Unterstützen von Substraten in Bestückautomaten.

Bei der Bestückung von Substraten (insbesondere Leiterplatten) mit oberflächenmontierbaren Bauelementen (SMD-Bauelementen) werden von Bestückautomaten die SMD-Bauelemente aus Zuführeinheiten entnommen und in einer vorgegebenen Position auf Substrate aufgesetzt. Das Substrat ruht dabei in der Regel auf zwei Seiten festgespannt in einem Transportband innerhalb des Bestückautomaten. Die Substrate, insbesondere die Leiterplatten, sind in der Praxis nie ideal eben, sondern entweder nach unten oder oben bis zu ca. 3 mm durchgewölbt. Sehr große und besonders dünne Leiterplatten hängen aufgrund des Eigengewichtes meistens nur nach unten durch. Da die Bauelemente mit einer gewissen Aufsetzkraft auf das Substrat gedrückt werden, um dort auf einem klebrigen Medium (z.B. Lotpaste, Kleber oder Flußmittel) haften zu bleiben, drückt die Saugpipette das Substrat nach unten und biegt sie dabei nach unten durch. Je nach gewünschter Aufsetzkraft und Steifigkeit des Substrats kann diese Durchbiegung im Bereich von Millimetern liegen. Durch die immer höher werdenden Maschinenleistungen ist zusätzlich die Aufsetzgeschwindigkeit der Saugpipette so groß, daß das Substrat wie durch einen Hammerschlag zu vertikalen Schwingungen angeregt wird. Diese Schwingungen sind einerseits schädlich für das Bauelement, das gerade von der Saugpipette bestückt wird, weil durch das Zurückfedern des Substrats nach oben zusätzliche Kraftstöße auf das Bauelement entstehen, die nicht kontrollierbar sind und empfindliche Bauteile zerstören können.

Andererseits sind die Auswirkungen auf die Setzgenauigkeit bei größeren Bauteilen mit feinem Raster der Anschlußbeinchen ungünstig. Das Bauelement wird beim Durchfedern des Substrats nach unten von der Pipette abgerissen, wenn die Haftkraft des klebrigen Mediums auf der Platte größer ist als die Saugkraft der Pipette oder es wird im anderen Fall wieder von dem klebrigen Medium hochgerissen, wenn die Pipettensaugkraft die Haftkraft übersteigt. Dies ist besonders bei Bauelementen der Fall, die in wenig haftenden Medien (z.B. dünnflüssige Flußmittel) plaziert werden. Wenn Bauteile auf diese Weise seitlich verrutschen, kann das Substrat im ungünstigsten Fall unbrauchbar werden oder später im Betrieb ausfallen.

Zusätzlich gibt es das Risiko, daß Bauelemente, die bereits auf dem Substrat sitzen, durch die Erschütterung beim Bestücken verrutschen oder sich lockern. Dies gilt wiederum für Bauelemente auf wenig haftenden Medien oder bei besonders schmalen, hohen oder schweren Bauelementen mit wenig Haftfläche.

Bisher werden daher in Bestückautomaten feste Substratunterstützungen verwendet. Dabei sind in der Regel mehrere, senkrecht nach oben stehende Stützstifte gleicher Länge auf einer Grundplatte angeordnet. Diese fahren vor dem Bestückvorgang von unten an die Leiterplatte heran, um sie zu unterstützen. Diese Unterstützung funktioniert allerdings nur dann, wenn die Stifte direkt an der Leiterplatte anliegen. Die Stützstifte müssen daher mit einem genau reproduzierbaren und justiertem Antrieb exakt so weit hochgefahren werden, bis sie das Substrat gerade berühren. Durch die Addition der Summentoleranzen von Substratauflagehöhe des Hubantriebes und der Ebenheit der Grundplatte über die gesamte Fläche ist dies in der Praxis aber nie exakt möglich.

Zur Unterstützung eines bestimmten Substrats müssen die Stützstifte an denjenigen Stellen positioniert werden, an denen das Substrat frei ist. Es dürfen dort keine Bauelemente bestückt sein, weil die Stützstifte sonst auf diese treffen und sie beschädigen können. Wenn dies am Rand in der Nähe der Einspannung passiert, wird das Substrat gewaltsam um die Bauelementhöhe nach oben überdrückt und gegebenenfalls ebenfalls beschädigt.

Die Anwendung fester Substratunterstützungen ist daher für den Anwender ein großer Aufwand, der geschultes und besonders gewissenhaftes Bedienpersonal erfordert. Dies ist um so aufwendiger, wenn pro Tag z.B,. drei bis zehn verschiedene Substrattypen produziert werden sollen, wobei in jedem , Bestückautomaten einer Linie die Anordnung der Unterstützungen genau so oft geändert werden muß.

Aus JP 9-181496 und JP 4-293300 sind Substratunterstützung mit höhenveränderlichen Stützstiften bekannt, bei der die einzelnen Stützstifte gefedert in Vertiefungen einer Grundplatte liegen und deren Höhenposition für alle Stützstifte gemeinsam durch die Verwendung von zwei mit Löchern für die Stützstifte versehenen Platten, die gegeneinander verschiebbar angeordnet sind, gewährleistet wird. Aufgrund der Vertiefungen in der Grundplatte lassen sich dabei nur bestimmte Anordnungen der Stützstifte realisieren.

Aus JP 2-190000 ist eine Substratunterstützung bekannt, bei der die Stützstifte durch magnetische Kopplung mit der Grundplatte verbunden sind. Eine Höhenverstellung der Stützstifte ist nicht offenbart.

Aus JP 6-209105 sind Stützstifte für eine Substratunterstützung bekannt, die individuell höhenverstellbar sind. Dabei ist nicht offenbart, wie die Fixierung der einzelnen Stützstifte realisiert ist.

JP 10-163 697 offenbart einen Stützstift zum Unterstützen von Susbtraten, wobei eine höhenverstellbare Spitze des Stützstiftes am einem Fußteil des Stützstiftes länsgsverschieblich gelagert ist.

Das Fußteil ist dabei durch einen Luftzylinder gebildet, der am eine Druckluftquelle angeschlossen ist.

Es ist daher die Aufgabe der Erfindung, eine Vorrichtung zum Unterstützen von Substraten in Bestückautomaten anzugeben, die bei einer flexibleren Handhabung besonders für gewölbte Substrate geeignet sind.

Die Aufgabe wird erfindungsgemäß durch eine Vorrichtung mit den Merkmalen des Anspruchs 1 sowie durch eine Grundplatte mit den Merkmalen des Anspruchs 4 gelöst.

Die Stützstifte sind dabei auf einer Grundplatte angebracht. Im Gegensatz zu den festen Stützstiften ist ihre Spitze gefedert. Der Hubtisch fährt im Betrieb mit der Grundplatte und den Stützstiften um ein paar Millimeter weiter hoch als bis zum Berühren der Substratunterseite nötig ist. Dadurch federn die Stifte um einen entsprechenden Überhub individuell ein und jeder einzelne Stützstift liegt mit einer geringen Federkraft an der Substratunterseite an. Die Stifte, die dabei auf einem Bauelement aufsetzen, federn jeweils um die Bauteildicke weiter ein. Im nächsten Schritt wird die individuell erreichte Höhenposition der Stützstifte mit Hilfe einer den jeweiligen Stützstiften individuell zugeordneten pneumatischen Bremse fixiert. Jeder einzelne Stützstift bleibt danach fest auf seiner eigenen Höhe, so daß das Substrat von dem Bestückautomaten beim Aufsetzen der Bauelemente nicht mehr durchgebogen und zu Schwingungen angeregt wird. Durch die individuelle Ausstattung der Stützstifte mit den pneumatischen Bremsen wird auch eine flexible Anordnung der Stützstifte auf der Grundplatte ermöglich.

Durch die erfindungsgemäße Lösung werden die Probleme unkontrollierter Aufsetzkräfte durch Zurückfedern der Leiterplatte, die schlechte Aufsetzgenauigkeit durch Abreißen des Bauelementes von der Saugpipette oder von dem klebrigen Medium sowie das Verrutschen schon gesetzter Bauteile auf der Leiterplatte vermieden. Die erfindungsgemäße Lösung wirkt auch unter ungünstigen Bedingungen, z.B. wenn das Substrat beliebig nach oben oder unten durchgewölbt ist, wenn schon Bauelemente an der Stelle bestückt sind, an der der einzelne Stützstift auf dem Substrat aufliegt, wenn die Herstellgenauigkeit der Unterstützung oder die Positioniergenauigkeit des Hubantriebes schlecht ist, oder wenn der Bediener die Stützstifte an ungeeigneten Stellen anordnet. Die Stützstifte müssen nicht bei jedem Produktwechsel an unterschiedlichen Stellen positioniert werden.

Gemäß Anspruch 2 wird in vorteilhafter Weise vorgeschlagen, daß die in Kontakt mit dem Substrat tretende Oberseite der Spitze des Stützstiftes aus Gummi gefertigt wird, um eventuell schon bestückte Bauelemente auf der Unterseite des Substrats nicht zu beschädigen. Eine einfache Herstellung eines stabilen Stützstiftes ist gemäß Anspruch 3 dadurch sichergestellt, daß der Fußteil sowie die Spitze des Stückstiftes rohrförmig ausgebildet sind.

Gemäß Anspruch 6 können in vorteilhafter Weise mehrere auf der Grundplatte befestigte Stützstifte gemeinsam fixiert werden, da die Grundplatte Druckluftleitungen für die Druckluftversorgung der jeweiligen pneumatischen Bremsen aufweist.

In einer vorteilhaften Ausgestaltung nach Anspruch 7 sind die Stützstifte in einem festen Raster angeordnet. Anhand des in der Zeichnung dargestellten Ausführungsbeispiels wird die Erfindung näher erläutert. Dabei zeigen
Figur 1 eine schematische Seitenansicht eines gewölbten Substrats, welches von einer Reihe von Stützstiften unterstützt wird,
Figur 2 einen Querschnitt durch einen erfindungsgemäßen Stützstift bei einer Positionierung in einem festen Raster auf einer Grundplatte und
Figur 3 einen Querschnitt durch einen erfindungsgemäßen Stützstift bei freier Positionierung auf der Grundplatte.

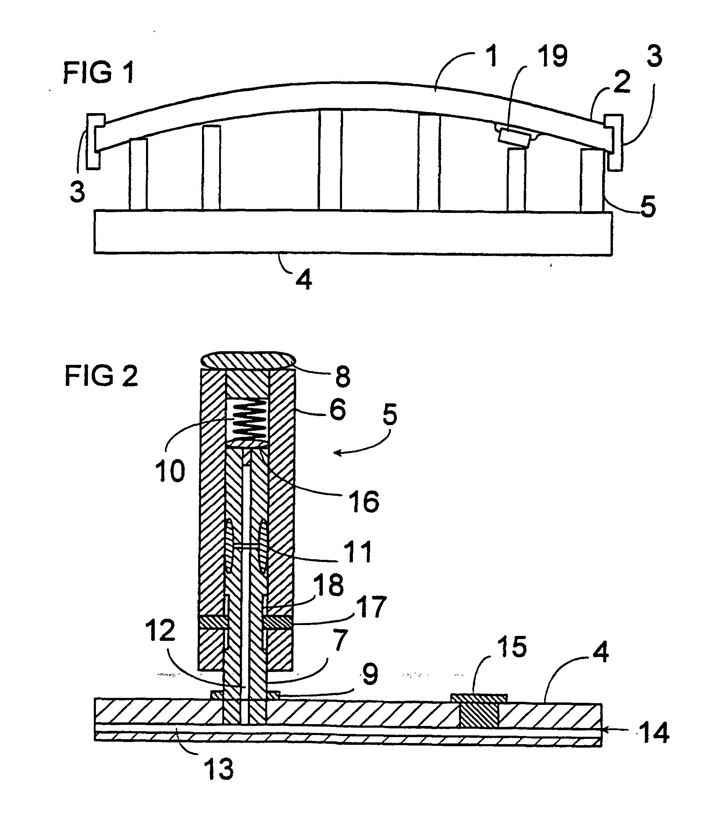

In Figur 1 ist in schematischer Seitenansicht ein nach oben gewölbtes Substrat 1 dargestellt, welches an den Substraträndern 2 von seitlichen Fixiervorrichtungen 3 gehalten wird. Die Transportrichtung des Substrats 1 im Bestückautomaten wird dabei in der Regel senkrecht zur Zeichenfläche ausgebildet sein. Nach dem seitlichen Fixieren des Substrats 1 fährt ein nicht dargestellter Hubtisch eine Grundplatte 4, auf der mehrere senkrecht nach oben stehende Stützstifte 5 in einem vorgegebenen Raster angeordnet sind, nach oben. Die Stützstifte 5 sind dabei individuell höhenverstellbar, so daß sich die Stützstifte 5 an die Kontur der Unterseite des Substrats 1 anpassen. Durch die individuelle Höhenverstellung der Stützstifte 5 können dabei auch bereits auf der Unterseite des Substrats bestückte Bauelemente 19 berücksichtigt werden, wie es beispielhaft am zweiten Stützstift von rechts dargestellt ist.

In Figur 2 ist im Querschnitt die Funktionsweise eine Stützstiftes 5 zusammen mit einer Grundplatte 4 dargestellt. Der Stützstift 5 umfaßt dabei eine Spitze 6 sowie ein Fußteil 7, welche leichtgängig gegeneinander verschiebbar sind. Die Spitze 6 ist dabei rohrförmig ausgebildet und umschließt den Fußteil 7. An der Oberseite der Spitze 6 ist ein Gummipfropfen 8 vorgesehen, damit beim Kontakt des Stützstiftes 5 mit dem Substrat 1 keine Beschädigungen an bereits bestückten Bauelementen 19 auf der Unterseite des Substrats 1 vorkommen. Das Fußteil 7 ist mit Befestigungsmitteln 9 an der Grundplatte 4 befestigt. Als Befestigungsmittel 9 kann dabei beispielsweise eine Schraubverbindung oder eine andere bekannte Befestigungsmöglichkeiten vorgesehen sein. Die Spitze 6 ist mit dem Fußteil 7 über eine Feder 10 gekoppelt, wodurch die Spitze 6 in ihrer Höhe verstellbar ist. Durch das Hochfahren der Grundplatte 4 und damit des Stützstiftes 5 wird die Feder 10 nach dem Kontakt der Spitze 6 mit dem Substrat 1 zusammengedrückt. Ist die Grundplatte 4 soweit hochgefahren, wie es vom Bediener vorgesehen ist, sollten alle Federn 10 der Stützstifte 5 in einem individuellen zusammengedrückten Zustand sein. In dieser Stellung wird die Höhenposition der Spitze 6 gegenüber der Grundplatte 4 fixiert. In Figur 2 ist dafür eine pneumatische Bremse 11 in Form eines Luftkissens dargestellt, die durch Druckluft betrieben wird. Dafür sind im Fußteil 7 eine Druckluftleitung 12 und in der Grundplatte 4 eine Druckluftleitung 13 vorgesehen, die miteinander in Verbindung stehen. Ein nicht näher dargestelltes Druckluftreservoir 14 versorgt die Druckluftleitungen mit Druckluft. Durch das Einschalten der Druckluft wird die pneumatische Bremse 11 nach außen gedrückt und arretiert die Position der Spitze 6 gegenüber dem Fußteil 7. Die Druckluftleitung 12 im Fußteil 7 ist dabei durch einen Abschluß 16 geschlossen. Ein Anschlag 17 und eine zugehörige Aussparung 18 im Fußteil 7 beschränken die Beweglichkeit der Spitze 6 gegenüber dem Fußteil 7. Durch einen Stopfen 15 werden nicht benutzte Löcher in der Grundplatte 4 verschlossen. Während des nachfolgenden Bestückvorgangs bleibt die Druckluft zugeschaltet, wodurch sämtliche Stützstifte 5 ihre Höhenposition behalten. Dadurch werden die unkontrollierten Aufsetzkräfte durch das Zurückfedern des Substrats verhindert, sowie die schlechte Aufsetzgenauigkeit durch das Abreißen des Bauelementes an der Saugpipette vermieden. Ebenfalls ist das Verrutschen schon gesetzter Bauelemente auf dem Substrat reduziert.

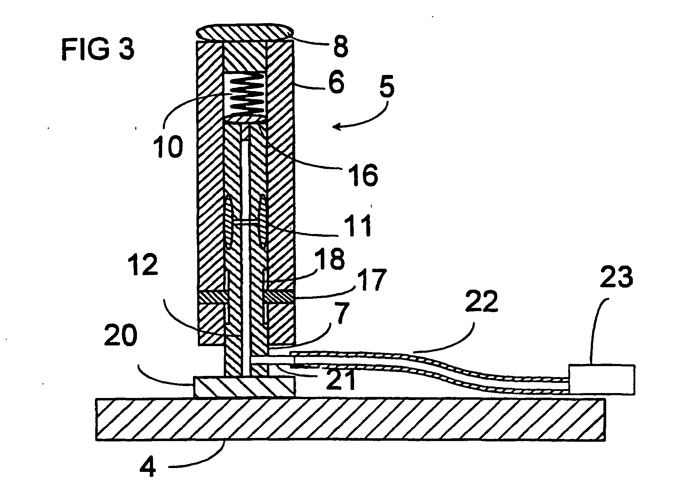

Ein weiteres Ausführungsbeispiel für die Stützstifte 5 ist in Figur 3 dargestellt. Durch einen Magnetfuß 20 werden die Stützstifte 5 auf der Grundplatte 4 aus magnetischem Material befestigt. Dadurch können die Stützstifte 5 frei auf der Grundplatte 4 positioniert werden, wodurch eine optimale Anpassung an die Form des Substrats 1 erreicht wird. Die Druckluft wird über einen Druckluftanschluß 21 am Stützstift 5 und einen flexiblen Schlauch 22 von einer zentralen Druckluftversorgung 23 zugeleitet.

Nach dem Bestückvorgang wird die Druckluft abgeschaltet, so daß die Stützstifte 5 beim Zurückfahren des Hubtisches wieder in den ausgefederten Zustand übergehen. Anschließend wird das Substrat 1 auch seitlich nicht mehr fixiert und kann weitertransportiert werden.

## Patentansprüche

1. Stützstift (5) zum Unterstützen von Substraten (1) in Bestückautomaten, wobei,
eine höhenverstellbare Spitze (6) des Stützstiftes (5) in einem Fußteil (7) des Stützstiftes (5) längsverschieblich gelagert ist und daß die Spitze (6) mittels einer schaltbaren pneumatischen Bremse (11) des Fußteiles (7) fixierbar ist, an welche eine zuschaltbare Druckluftquelle (14) angeschlossen ist.

2. Stützstift (5) zum Unterstützen von Substraten (1) in Bestückautomaten nach Anspruch 1,
**dadurch gekennzeichnet,**
**daß** die in Kontakt mit dem Substrat (1) tretende Oberseite der Spitze (6) aus Gummi (8) gebildet ist.

3. Stützstift (5) zum Unterstützen von Substraten (1) in Bestückautomaten nach einem der Ansprüche 1 oder 2,
**dadurch gekennzeichnet,**
**daß** der Fußteil (7) rohrförmig ausgebildet ist, daß die Spitze (6) rohrförmig ausgebildet ist und das Fußteil (8) seitlich umschließt.

4. Grundplatte mit einer Mehrzahl von Stützstiften nach einem der Ansprüche 1 und 3,
**dadurch gekennzeichnet,**
**daß** die Grundplatte (4) Druckluftleitungen (13) aufweist, über die an der Grundplatte (4) anzuordnende Stützstifte (5) mit Druckluft versorgt werden.

5. Grundplatte nach Anspruch 4,
**dadurch gekennzeichnet,**
**daß** die Spitze (6) der Stützstifte (5) gegenüber der Grundplatte (4) gefedert gelagert ist.

6. Grundplatte nach Anspruch 5,
**dadurch gekennzeichnet,**
**daß** die Grundplatte (4) Druckluftleitungen (13) für die Druckluftversorgung der pneumatischen Bremse (11) aufweist.

7. Grundplätte nach einem der Ansprüche 5 oder 6,
**dadurch gekennzeichnet,**
**daß** die Stützstifte (5) in einem festen Raster angeordnet sind.

8. Grundplatte nach Anspruch 5,
**dadurch gekennzeichnet,**
**daß** die Stützstifte (5) magnetisch auf der Grundplatte (4) befestigt sind und
**daß** die Stützstifte einen Druckluftanschluß (21) aufweisen, der über einen Schlauch (22) mit einer zentralen Druckluftversorgung (23) verbunden ist.

## Claims

1. Support rod (5) for supporting substrates (1) in component-mounting machines, whereby
a vertically adjustable pin (6) of the support rod (5) is housed longitudinally in a leg (7) of the support rod (5) and whereby the pin (6) can be locked in place by means of a switchable pneumatic brake (11) of the leg (7), to which is connected a switchable compressed-air source (14).

2. Support rod (5) for supporting substrates (1) in component-mounting machines according to Claim 1,
**characterized in that**
the upper surface of the pin (6) that comes into contact with the substrate (1) is made of rubber (8).

3. Support rod (5) for supporting substrates (1) in component-mounting machines according to one of Claims 1 or 2,
**characterized in that**
the leg (7) is designed in the form of a tube, the pin (6) is designed in the form of a tube and laterally encloses the leg (8).

4. Base plate (4) for fastening a plurality of support rods according to one of Claims 1 and 3,
**characterized in that**
the base plate (4) has compressed-air lines (13), via which the support rods (5) to be arranged on the base plate (4) are supplied with compressed air.

5. Base plate according to Claim 4,
**characterized in that**
the pin (6) of the support rod (5) is compressed against the base plate by a spring (4).

6. Base plate according to Claim 5,
**characterized in that**
the base plate (4) has compressed-air lines (13) for supplying compressed air to the pneumatic brake (11).

7. Base plate according to one of Claims 5 or 6,
**characterized in that**
the support rods (5) are arranged in a fixed grid.

8. Base plate according to Claim 5,
**characterized in that**
the support rods (5) are magnetically fastened to the base plate (4), and the support rods have a compressed-air connection (21) which is connected to a central compressed-air supply (23) via a hose (22).

## Revendications

1. Tige de soutien (5) pour soutenir des substrats (1) dans des automates d'implantation de composants, dans laquelle
une pointe (6), ajustable en hauteur, de la tige de soutien (5) est montée à coulissement longitudinal dans une pièce de pied (7) de la tige de soutien (5), la pointe (6) pouvant être immobilisée au moyen d'un frein pneumatique (11) prévu sur la pièce de pied (7) et connecté à une source (14) d'air sous pression raccordable.

2. Tige de soutien (5) pour soutenir des substrats (1) dans des automates d'implantation de composants selon la revendication 1,
**caractérisée en ce**
**que** le côté supérieur de la pointe (6), qui entre en contact avec le substrat (1), est réalisé en caoutchouc (8).

3. Tige de soutien (5) pour soutenir des substrats (1) dans des automates d'implantation de composants selon l'une des revendications 1 ou 2,
**caractérisée en ce**
**que** la pièce de pied (7) a une configuration tubulaire et
**que** la pointe (6) a une configuration tubulaire et entoure latéralement la pièce de pied (8).

4. Plaque de base dotée d'une pluralité de tiges de soutien selon l'une des revendications 1 et 3,
**caractérisée en ce**
**que** la plaque de base (4) présente des conduits (13) d'air comprimé par lesquels les tiges de soutien (5) qui doivent être disposées sur la plaque de base (4) sont alimentées en air comprimé.

5. Plaque de base selon la revendication 4,
**caractérisée en ce**
**que** la pointe (6) des tiges de soutien (5) est montée élastiquement par rapport à la plaque de base (4).

6. Plaque de base selon la revendication 5,
**caractérisée en ce**
**que** la plaque de base (4) présente des conduits (13) d'air comprimé pour l'alimentation en air comprimé des freins pneumatiques (11).

7. Plaque de base selon l'une des revendications 5 et 6,
**caractérisée en ce**
**que** les tiges de soutien (5) sont disposées suivant un motif fixe.

8. Plaque de base selon la revendication 5,
**caractérisée en ce**
**que** les tiges de soutien (5) sont fixées magnétiquement sur la plaque de base (4) et
**que** les tiges de soutien présentent un raccordement (21) au moyen d'un tuyau (22), à l'air comprimé qui est relié à une alimentation centrale (23) en air comprimé.
